# EUROPÄISCHE PATENTANMELDUNG

(11) **EP 3 952 112 A1**
(43) Veröffentlichungstag der Anmeldung: **09.02.2022**
(21) Anmeldenummer: 21194086.1
(22) Anmeldetag: 20.12.2019
(51) Int. Cl.: H03K 17/95, H03K 17/97

(54) **VERFAHREN ZUM ERFASSEN EINER ORTSÄNDERUNG EINES METALLISCHEN BETÄTIGUNGSELEMENTS**

(30) Priorität: 17.01.2019 DE 102019101186
(62) Teilanmeldung aus: 19218771.4
(71) Anmelder: Huf Hülsbeck & Fürst GmbH & Co. KG, 42551 Velbert (DE)
(72) Erfinder: SIEG, Berthold, 46240 Bottrop (DE); WENNER, Christian, 33428 Harsewinkel (DE)
(74) Vertreter: Zenz Patentanwälte Partnerschaft mbB

(57) **Zusammenfassung**

Verfahren zum Erfassen einer Ortsänderung eines metallischen Betätigungselements, das an einer Betätigungsanordnung eines Kraftfahrzeugs angeordnet ist oder Bestandteil der Betätigungsanordnung des Kraftfahrzeug ist, relativ zu einer als induktiver Sensor fungierenden Spule eines Schwingkreises, wobei die folgenden Schritte durchgeführt werden:

## Beschreibung

Die Erfindung betrifft ein Verfahren zum Erfassen einer Ortsänderung eines metallischen Betätigungselements, beispielsweise mittels einer Betätigungsanordnung eines Kraftfahrzeugs.

Induktive Sensoranordnungen spielen bei modernen Kraftfahrzeugen zunehmend eine Rolle, beispielsweise als Sensor für eine Betätigung eines sogenannten feststehenden Türgriffs. Das Funktionsprinzip induktiver Sensoranordnungen beruht auf der Erkennung einer Veränderung eines elektromagnetischen Felds, wenn ein metallisches oder ferromagnetisches Betätigungselement sich in dem elektromagnetischen Feld bewegt. Der zu Grunde liegende physikalische Effekt ist die Änderung der Induktivität und/oder der Güte der Induktivität infolge einer Lageänderung des leitfähigen und/oder ferromagnetischen Elements relativ zu dem die Induktivität erzeugenden Bauteil. Bei dem leitfähigen oder ferromagnetischen Element kann es sich beispielsweise um einen Betätigungsbereich einer Handhabe eines Türgriffs oder um einen Teil eines Betätigungsbereichs der Handhabe des Türgriffs handeln. Dadurch, dass mit induktiven Sensoren auch geringfügige Lageänderungen, beispielsweise im Mikrometerbereich, erkannt werden können, ist die Nutzung induktiver Sensoren insbesondere bei den zunehmend verwendeten sogenannten feststehenden Türgriffen interessant.

Bei der Bereitstellung von Betätigungsanordnungen mit induktiven Sensoranordnungen ist eine zuverlässige Erfassung einer Ortsänderung eines metallischen Betätigungselements wichtig. Außerdem ist wünschenswert, dass die Betätigungsanordnung wirtschaftlich herstellbar ist.

Aufgabe der Erfindung ist es, eine Alternative für bereits existierende Betätigungsanordnungen bereitzustellen. Die zu findenden Überlegungen sollen eine ausreichend zuverlässige Erfassung einer Ortsänderung eines Betätigungselements erwarten lassen und eine Herstellung einer Betätigungsanordnung mit vernünftiger Wirtschaftlichkeit erlauben.

Die Aufgabe wird gelöst mit einem Verfahren zum Erfassen einer Ortsänderung eines metallischen Betätigungselements.

Es ist eine nicht erfindungsgemäße Betätigungsanordnung eines Kraftfahrzeugs vorgesehen. Die Betätigungsanordnung weist eine induktive Sensoranordnung auf. Die induktive Sensoranordnung dient der Erfassung einer Ortsänderung eines metallischen Betätigungselements relativ zu der Sensoranordnung. Der Begriff der Ortsänderung umfasst auch eine Lageänderung des Betätigungselements, beispielsweise infolge einer Verkippung oder einer Verformung.

Die Sensoranordnung weist alle erforderlichen Elemente auf, um ein Magnetfeld, genauer: elektromagnetisches Feld, zu erzeugen und eine Veränderung des Magnetfelds durch das metallische Betätigungselement erkennen zu können. Die induktive Sensoranordnung weist somit insbesondere eine Spule auf, die als induktiver Sensor dient und als für die Bereitstellung der gewünschten Funktionalität wesentliches Bauelement der induktiven Sensoranordnung ist.

Das metallische Betätigungselement kann Bestandteil der Betätigungsanordnung sein, kann aber auch als nicht zu der Betätigungsanordnung gehörendes Element angesehen werden oder vorgesehen sein. Wesentlich ist, dass die Sensoranordnung zur Erzeugung eines Magnetfelds eingerichtet ist und in der Lage ist, eine Ortsänderung des metallischen Betätigungselements innerhalb des Magnetfelds zu erkennen. Daraus ergibt sich die selbstverständliche Anforderung an den zur Ausführung der Erfindung beauftragten Fachmann, Ausdehnung und Positionierung von Magnetfeld einerseits sowie Ausformung und Positionierung des Betätigungselements andererseits aufeinander hin anzupassen. Dies ist aber für die prinzipielle Funktionsweise der vorliegenden Erfindung nicht wesentlich, solange das Betätigungselement bei Ortsänderung innerhalb vorgegebener Parameter das Magnetfeld beeinflusst.

Die Sensoranordnung weist, wie bereits angedeutet, den induktiven Sensor auf, der als Spule ausgebildet ist. Die Sensoranordnung weist ferner eine Kapazität auf, die bevorzugt als ein kapazitives Bauelement oder mehrere kapazitive Bauelemente ausgebildet ist und die gemeinsam mit der Spule als Bestandteil eines elektrischen Schwingkreises der Betätigungsanordnung ist.

Bevorzugt sind die Kapazität und die Spule parallel zueinander in einem Parallelschwingkreis angeordnet.

Die Sensoranordnung weist außerdem einen Mikrocontroller auf, der mit dem Schwingkreis gekoppelt ist, das heißt bevorzugt: galvanisch verbunden ist. Ein erster Ausgang des Mikrocontrollers ist mit dem Schwingkreis gekoppelt, um den Schwingkreis mit einer Anregungsspannung anzuregen, die durch den Mikrocontroller bereitgestellt wird.

Der Schwingkreis ist außerdem an einem ersten Spannungsabgriff mit dem Mikrocontroller gekoppelt, wobei der erste Spannungsabgriff und ein erster Eingangspin des Mikrocontrollers miteinander verbunden sind zum Erfassen einer an dem Schwingkreis anfallenden Spannung mittels des Mikrocontrollers.

Die Sensoranordnung weist ferner einen Leitungszweig auf, der in Parallelschaltung zum Schwingkreis angeordnet ist. Ein zweiter Spannungsabgriff führt von diesem Leitungszweig ausgehend in einen zweiten Eingangspin des Mikrocontrollers hinein, um eine an dem Leitungszweig anfallende Spannung zu erfassen.

Die Sensoranordnung weist also eine elektrische Schaltung auf, in welcher zumindest ein elektrischer Schwingkreis aus Kapazität und Spule, bevorzugt in Parallelschwingkreis ausgebildet, sowie ein parallel zu dem Schwingkreis geschalteter Leitungszweig vorgesehen sind, wobei sowohl an dem Schwingkreis als auch an dem parallel zum Schwingkreis angeordneten Leitungszweig jeweils ein Spannungsabgriff angeordnet ist, und wobei von jedem der beiden Spannungsabgriffe ausgehend eine Leitung zu dem Mikrocontroller hin und in diesen hineinführt. Jede der beiden Leitungen führt jeweils in einen separaten Eingangspin hinein. Die von dem ersten Spannungsabgriff wegführende Leitung führt in den ersten Eingangspin hinein und die von dem zweiten Spannungsabgriff wegführende Leitung führt in den zweiten Eingangspin hinein.

Der Mikrocontroller ist durch die erläuterte Konstellation in der Lage, an zwei parallelen Zweigen der Schaltung, nämlich dem Schwingkreiszweig und dem parallel zum Schwingkreis angeordneten Leitungszweig, zeitabhängig Spannungen zu erfassen.

Der Mikrocontroller kann also in zeitaufgelöster Weise sowohl einen über dem Schwingkreis abfallenden Spannungswert erfassen, was über die in den ersten Eingangspin hineingeführte Leitung erfolgt, als auch einen über dem parallelen Leitungszweig abfallende Spannungswert erfassen, was über den in den zweiten Eingangspin hineingeführte Leitung erfolgt.

Der Mikrocontroller ist eingerichtet, nachdem er an dem zweiten Eingangspin eine Startspannung erfasst hat, in Reaktion auf das Erfassen der Startspannung mit einem Zeitmesser des Mikrocontrollers einen Startzeitpunkt festzulegen. Der Mikrocontroller überwacht also, ob er an dem zweiten Eingangspin eine Schwellwertüberschreitung einer Startspannung feststellen kann. In Reaktion auf das Erfassen der Schwellwertüberschreitung wird mit einem Zeitmesser des Mikrocontrollers ein Startzeitpunkt festgelegt, beispielsweise durch Starten eines als Timer des Mikrocontroller ausgebildeten Zeitmessers. Bei einem nach dem Erfassen der Schwellwertüberschreitung nächsten Feststellen einer Schwellwertüberschreitung einer vorgegebenen Stoppspannung mit dem ersten Eingangspin wird mit dem Zeitmesser, der beispielsweise der Timer des Mikrocontroller ist, der seit dem Startzeitpunkt vergangene Zeitraum ermittelt.

Das bedeutet mit anderen Worten: Der Mikrocontroller überwacht den zweiten Pin darauf, ob ein Schwellwert einer Startspannung überschritten wird. In dem Moment, wo der Mikrocontroller erfasst, dass eine Schwellwertüberschreitung der, von dem mit der Umsetzung der Erfindung betrauten Fachmann vorgegebenen, Startspannung erfasst wird, wird unverzüglich nach Erfassen der Schwellwertüberschreitung der Startzeitpunkt festgelegt und in dem Moment, in dem mit dem ersten Eingangspin das Überschreiten einer vorgegebenen Stoppspannung erkannt wird, mit dem Zeitmesser der Zeitraum ermittelt, der seit dem Startzeitpunkt vergangen ist.

Mit anderen Worten ausgedrückt, dient die Spannung, die an dem parallel zum Schwingkreis angeordneten Leitungszweig abfällt, als Ereignis, welches den Startzeitpunkt definiert, beispielsweise indem der Timer des Mikrocontrollers gestartet wird. Das Überschreiten der Stoppspannung, das mit dem ersten Eingangspin erfasst wird, und welches aufgrund der zeitlichen Verzögerung in der Reaktion von Spule und Kondensator des Schwingkreises erst in einer gewissen Zeit dem Spannungsaufbau über dem parallel zum Schwingkreis angeordneten Leitungszweig nachfolgt, diesem also hinterherläuft, bestimmt den seit dem Startzeitpunkt vergangenen Zeitraum. Der seit dem Startzeitpunkt vergangene Zeitraum wiederum ist ein Maß für die Trägheit des Schwingkreises und damit für die Induktivität und/oder der Güte der Induktivität des Gesamtsystems aus Spule und Betätigungselement.

Die Werte für Startspannung und Stoppspannung einerseits und von Anregungsspannung und Dimensionierung der Sensoranordnung, insbesondere des Schwingkreises, andererseits sind derart aneinander angepasst zu wählen, dass die Ausgabe der Anregungsspannung am ersten Ausgang des Mikrocontrollers eine Schwellwertüberschreitung der Startspannung sowie eine Schwellwertüberschreitung der Stoppspannung zur Folge hat. Diese Voraussetzung für die Funktionsfähigkeit der Betätigungsanordnung und des Verfahrens ist selbsterklärend und als reine Frage der Auslegung der Sensoranordnung für den ausführenden Fachmann unproblematisch zu bewerkstelligen.

Zur Klarstellung sei ausgeführt, dass der seit dem Startzeitpunkt vergangene Zeitraum endet mit dem Erfassen des Überschreitens der Stoppspannung zuzüglich einer in allen elektrischen Systemen unvermeidlichen Reaktionszeit, die beispielsweise eine Reaktion des Mikrocontrollers umfasst. Die Reaktionszeit ist unabhängig von einer Änderung von Induktivität und/oder Güte der Induktivität und stellt somit eine Art Offset dar, der das Funktionsprinzip der Betätigungsanordnung nicht beeinträchtigt. Dem Fachmann obliegt bei Realisierung der beschriebenen Erfindung lediglich die Aufgabe, die einzelnen Bestandteile der Betätigungsanordnung derart zu wählen und zu dimensionieren, dass eine Änderung des ermittelten Zeitraums bei Betätigung der Betätigungsanordnung genügend groß im Vergleich zu der unvermeidlichen Reaktionszeit ist, um die Betätigung mit gewünschter Sicherheit identifizieren zu können.

Das Ermitteln des Zeitraums, der sich von dem Startzeitpunkt bis zum durch das erkannte Überschreiten der Stoppspannung und addierter unvermeidlicher Reaktionszeit definierten Reaktionszeitpunkt erstreckt, kann auf verschiedene Weise erfolgen.

Beispielsweise kann in Reaktion auf das Erfassen der Schwellwertüberschreitung und unverzüglich nach dem Erfassen der Schwellwertüberschreitung, das heißt abgesehen von elektrotechnischen und physikalischen Limitierungen sofort, ein Timer des Mikrocontrollers gestartet werden. Bei Erfassen des Überschreitens der vorgegebenen Stoppspannung und in Reaktion auf das Erfassen des Überschreitens der Stoppspannung wird der Timer unverzüglich wieder gestoppt, der Mikrocontroller kennt somit den zwischen Startzeitpunkt und Reaktionszeitpunkt vergangenen Zeitraum.

Alternativ kann vorgesehen sein, dass sowohl der Startzeitpunkt als auch der Stoppzeitpunkt in einem Speicher abgelegt werden und mit einer nachfolgenden Operation, insbesondere einer Subtraktion des Startzeitpunkts von dem Reaktionszeitpunkt, der zwischen Startzeitpunkt und Reaktionszeitpunkt vergangene Zeitraum ermittelt wird.

Wesentlich ist, dass der Mikrocontroller den Zeitpunkt einer erkannten Schwellwertüberschreitung der Startspannung an dem parallel zum Schwingkreis angeordneten Leitungszweig und den Zeitpunkt eines Überschreitens der vorgegebenen Stoppspannung an dem Schwingkreis erfasst und einen zwischen den Zeitpunkten liegenden Zeitraum ermittelt.

Eine Änderung der Induktivität des Gesamtsystems Spule und metallisches Betätigungselement äußert sich in einer Änderung der Zeitabhängigkeit der an den Schwingkreis anfallenden Spannung. Beispielsweise ändert sich die Zeitkonstante des Schwingkreises. Das bedeutet, dass der ermittelte Zeitraum zwischen Startzeitpunkt und Reaktionszeitpunkt eine für die Ortsänderung eines metallischen Betätigungselement charakteristische Größe ist. Das Erfassen dieser charakteristischen Größe erfolgt über ein Festlegen des Zeitraums über zwei Ereignisse. Das erste Ereignis ist das Überschreiten eines Schwellwerts an einem parallel zum Schwingkreis angeordneten Leitungszweig, das mit dem zweiten Eingangspin erfasst wird. Das zweite Ereignis ist das Erfassen eines Überschreitens einer vorgegebenen Stoppspannung mit dem ersten Eingangspin. Dadurch, dass die induktive Sensoranordnung mit in einem elektrischen Schwingkreis angeordneter Spule, einem zum Schwingkreis parallelen Leitungszweig und dem in der beschriebenen Weise mit beiden gekoppelten Mikrocontrollern keine weiteren Elemente benötigt, handelt es sich bei der beschriebenen Auswertungsanordnung um eine wirtschaftlich herstellbare Sensoranordnung, die mit hoher Detektionsgeschwindigkeit eine Betätigungserkennung ermöglicht.

Die Anregungsspannung wird bevorzugt als Spannungspuls ausgegeben, besonders bevorzugt als Rechteckpuls.

Die Anregungsspannung ist dabei zumindest zeitweise periodisch wiederholt, wobei gegebenenfalls der Zeitraum zwischen Startzeitpunkt und Reaktionszeitpunkt über mehrere Perioden separat ermittelt werden kann und ein Mittelwert gebildet werden kann, um den Einfluss von Fehlmessungen zu reduzieren.

Besonders bevorzugt ist der Mikrocontroller eingerichtet, die Anregungsspannung auszugeben in Reaktion auf den Erhalt eines Näherungssignals eines Näherungssensors, der mit dem Mikrocontroller gekoppelt ist. Beispielsweise kann der Mikrocontroller mit einer kapazitiven Sensorelektrode gekoppelt sein, die bei Erfassen einer Annäherung ein Sensorsignal ausgibt, das der Mikrocontroller als solches erkennt, woraufhin der Mikrocontroller in Reaktion auf das Sensorsignal die Anregungsspannung ausgibt, um mittels der oben dargelegten Funktionsweise eine Ortsänderung des metallischen Betätigungselements zu erkennen.

Beispielsweise kann vorgesehen sein, dass nach dem Erhalt des Näherungssignals durch den Mikrocontroller die Anregungsspannung während eines vorgegebenen Zeitraums, beispielsweise während eines Zeitraums von zwischen 10 Sekunden bis 5 Minuten, wiederholt einen Spannungspuls ausgibt und für jeden ausgegebenen Spannungspuls den von dem Startzeitpunkt zu dem Reaktionszeitpunkt sich erstreckenden Zeitraum ermittelt. Dadurch kann eine Betätigung der Betätigungsanordnung mit einhergehender Lageänderung des metallischen Betätigungselements von der Betätigungsanordnung erkannt werden und gegebenenfalls hierauf hin ein Betätigungssignal an eine kraftfahrzeugseitige Einrichtung, beispielsweise an ein Türschloss, ausgegeben werden. Da eine Betätigung des Betätigungselements zwangsläufig immer eine Annäherung eines Bedieners voraussetzt, kann mit der Kopplung der Überwachung des Betätigungselements an eine Erkennung einer Annäherung eine Energieaufnahme des Mikrocontrollers und der mit ihm gekoppelten Schaltungen in ihrem Ausmaß reduziert werden.

Bevorzugt ist der Annäherungssensor innerhalb der Betätigungsanordnung angeordnet. Dadurch lässt sich in besonders zuverlässiger Weise die Überwachung auf eine Ortsänderung des metallischen Betätigungselements mit der Annäherung, beispielsweise einer Hand eines Bedieners, an die Betätigungsanordnung verknüpfen. Dadurch wird erreicht, dass die Überwachung auf eine Betätigung auf Zeiträume beschränkt ist, in denen eine Betätigung auch wahrscheinlich ist.

Der Mikrocontroller ist in einer bevorzugten Ausführungsform eingerichtet, eine Auswertung des ermittelten Zeitraums zwischen dem Startzeitpunkt und dem Reaktionszeitpunkt durchzuführen zur Erfassung der Ortsänderung des metallischen Betätigungselements relativ zu der Spule. Innerhalb des Mikrocontrollers selbst wird somit der gemäß eingangs erläuterter Vorgehensweise ermittelte Zeitraum, der sich zwischen Startzeitpunkt und Reaktionszeitpunkt erstreckt, daraufhin ausgewertet, ob der Zeitraum darauf hindeutet, dass eine Ortsänderung eines metallischen Betätigungselements, beispielsweise eine Ortsänderung aus einer Gleichgewichtslage heraus, erfolgt ist. Sofern dies der Fall ist, kann beispielsweise aus der erkannten Ortsänderung auf eine Betätigung geschlussfolgert werden und diese beispielsweise zu einer Ausgabe eines Betätigungssignals an eine fahrzeugseitige Einrichtung, beispielsweise an ein Türschloss führen.

Gemäß einer Ausführungsform umfasst die von dem Mikrocontroller durchgeführte Auswertung, dass der ermittelte Zeitraum mit einem Referenzwert verglichen wird, der in dem Speicher des Mikrocontrollers hinterlegt ist. Der Mikrocontroller stellt gemäß dieser Ausführung daraufhin in Abhängigkeit von dem Ergebnis des Vergleichs die Betätigung des Betätigungselements fest.

Beispielsweise kann der Referenzwert eine Minimalabweichung eines ermittelten Zeitraums in der Betätigungssituation von dem ermittelten Zeitraum in der Gleichgewichtssituation, das heißt ohne Betätigung, repräsentieren und es wird eine Betätigung festgestellt, wenn der ermittelte Zeitraum wenigstens mit der Minimalabweichung von dem ermittelten Zeitraum in der Gleichgewichtssituation abweicht. Nach Feststellen der Betätigung wird ein Betätigungssignal ausgegeben, das beispielsweise von einem kraftfahrzeugseitigen Steuergerät als Auslöser für eine Bedienaktion, beispielsweise eine Türöffnung, interpretiert werden kann.

Alternativ oder zusätzlich kann zur Auswertung der ermittelte Zeitraum mit einer Referenztabelle verglichen werden, die auf dem Mikrocontroller hinterlegt ist. In diesem Fall kann aus dem Vergleich ein Ortsänderungsmaß des Betätigungselements ermittelt werden. Das kann gemäß einer Ausführungsvariante derart umgesetzt sein, dass die Referenztabelle unterschiedlichen Intervallen von festgestellten Zeiträumen unterschiedliche Auslenkungen des Betätigungselements aus seiner Gleichgewichtslage zuordnet. Basierend auf dieser Konstellation wird durch Vergleich des ermittelten Zeitraums mit der Referenztabelle und Feststellen, in welchem Zeitraumintervall der festgestellte Zeitraum sich befindet, ein Maß der Auslenkung des Betätigungselements ermittelt. Insbesondere kann die Referenztabelle für eine Anzahl von wenigstens zwei Zeitraumintervallen jeweils Ortsänderungsmaße, beispielsweise Auslenkungen, des Betätigungselements zuordnen und diese als Basis für die Ermittlung des Ortsänderungsmaßes nutzen.

Dies hat unter anderem den Vorteil zur Folge, dass mit demselben Betätigungselement unterschiedliche Aktionen ausgelöst werden können. Beispielsweise kann bei einer geringen Ortsänderung, beispielsweise aufgrund von einer vergleichsweise geringen Kraftausübung auf das Betätigungselement, eine erste Aktion ausgelöst werden und bei einer stärkeren Kraftausübung, und dadurch einer größeren Ortsänderung, eine alternative oder zusätzliche Aktion ausgelöst werden.

Gemäß einer bevorzugten Ausführungsform ist die Betätigungsanordnung ein Türgriff einer Fahrzeugtür oder einer Fahrzeugklappe, wobei die induktive Sensoranordnung zumindest teilweise innerhalb des Türgriffs angeordnet ist. Das Betätigungselement ist bevorzugt an dem Türgriff angeordnet oder Bestandteil des Türgriffs. Bevorzugt ist das Betätigungselement als Bestandteil eines Hüllenabschnitts des Türgriffs ausgebildet.

Ein weiterer Gedanke der Erfindung betrifft ein Verfahren zum Erfassen einer Ortsänderung eines metallischen Betätigungselements. Das Betätigungselement ist an einer Betätigungsanordnung eines Kraftfahrzeugs angeordnet. Alternativ kann das Betätigungselement Bestandteil der Betätigungsanordnung des Kraftfahrzeugs sein. Die Lage des Betätigungselements ist relativ zu einer Spule eines Schwingkreises beweglich, wobei der Schwingkreis, genauer: die Spule des Schwingkreises, als induktiver Sensor dient.

Für die Erfassung einer Ortsänderung eines metallischen Betätigungselements, das an einer Betätigungsanordnung eines Kraftfahrzeugs angeordnet ist oder Bestandteil der Betätigungsanordnung des Kraftfahrzeugs ist, relativ zu einer als induktiver Sensor fungierenden Spule eines Schwingkreises, werden zumindest die folgenden Schritte durchgeführt:
1) Es erfolgt ein Anregen des Schwingkreises mit einer Anregungsspannung. Bevorzugt wird die Anregungsspannung mit einem Mikrocontroller bereitgestellt, beispielsweise als Ausgangsspannung, die an einem Ausgangspin des Mikrocontrollers abgegriffen wird.
2) Die an dem Schwingkreis abfallende Spannung wird zeitabhängig überwacht. Dies kann beispielsweise mittels eines ADCs desselben Mikrocontrollers erfolgen.
3) Das Feststellen einer Betätigung erfolgt in Abhängigkeit von der überwachten Spannung.

Um die Ortsänderung des metallischen Betätigungselements zu erkennen, werden in einer ersten, nicht erfindungsgemäßen, Variante zumindest die folgenden Schritte durchgeführt:
a) Die an dem Schwingkreis abfallende Spannung wird zeitabhängig überwacht, wofür der erste Eingangspin eines Mikrocontrollers genutzt wird.
b) Die an einem parallel zum Schwingkreis angeordneten Leitungszweig abfallende Spannung wird zeitabhängig überwacht mittels eines zweiten Eingangspins des Mikrocontrollers.
   Der erste Eingangspin und der zweite Eingangspin sind mit einem selben Zeitmesser des Mikrocontrollers gekoppelt.
c) Wenn die mit dem zweiten Eingangspin ermittelte Spannung eine vorgegebene Startspannung überschreitet, wird unverzüglich nach dem Feststellen der Überschreitung ein Startzeitpunkt erfasst. Das bedeutet, dass die Feststellung, dass die mit dem zweiten Eingangspin überwachten Spannung die Startspannung überschritten hat, den Startzeitpunkt festlegt. Der Startzeitpunkt ist der Zeitpunkt, an dem die Startspannung überschritten wird zuzüglich der elektrotechnisch und physikalisch unvermeidlichen Verzögerungen beim Feststellen der Überschreitung.
d) Sobald die mit dem ersten Eingangspin ermittelte Spannung die vorgegebene Stoppspannung das unmittelbar auf den in Schritt c) festgelegten Startzeitpunkt folgende Mal überschreitet, wird der Zeitraum erfasst, der seit dem Startzeitpunkt vergangen ist. Mit anderen Worten dient das Erkennen des Überschreitens der Startspannung dem Festlegen des Starts des Zeitraums und das Erkennen des Überschreitens der Stoppspannung dem Festlegen des Stoppzeitpunkts. Der Zeitraum zwischen Startzeitpunkt und Stoppzeitpunkt hängt von der Induktivität des Gesamtsystems "Spule-metallisches Betätigungselement" ab.
   Aus diesem Grund wird in einem anschließenden Schritt
e) eine Auswertung des ermittelten Zeitraums vorgenommen, mit der festgestellt wird, ob eine Ortsänderung des metallischen Betätigungselements als erfasst angesehen werden kann oder nicht.

Gemäß einer nicht erfindungsgemäßen Ausführungsform des Verfahrens umfasst das Auswerten des ermittelten Zeitraums, dass der Mikrocontroller den ermittelten Zeitraum mit einem auf dem Speicher des Mikrocontrollers hinterlegten Referenzwert vergleicht und eine Betätigung des Betätigungselements feststellt in Abhängigkeit von dem Ergebnis des Vergleichs und/oder der Mikrocontroller den ermittelten Zeitraum mit einer auf dem Mikrocontroller hinterlegten Referenztabelle vergleicht, wobei die Referenztabelle einer Anzahl von wenigstens zwei Zeitraumintervallen jeweils Ortsänderungsmaße des Betätigungselements zuordnet, so dass der Mikrocontroller aus dem Vergleich das Ortsänderungsmaß des Betätigungselements ermittelt.

Besonders bevorzugt wird die Auswertung in einer der Varianten durchgeführt, wie sie eingangs in Zusammenhang mit der weitergebildeten Ausführungsformen der Betätigungsanordnung beschrieben sind.

Insbesondere kann vorgesehen sein, dass eine Betätigung festgestellt wird, wenn der ermittelte Zeitraum um wenigstens eine Minimalabweichung von einem bei Nichtbetätigung erwarteten und als Referenzwert hinterlegten Zeitraum abweicht. Nach Feststellen der Betätigung wird ein Betätigungssignal ausgegeben, das beispielsweise von einem kraftfahrzeugseitigen Steuergerät als Auslöser für eine Bedienaktion, beispielsweise eine Türöffnung, interpretiert werden kann.

In einer alternativen, erfindungsgemäßen, Variante sieht das Verfahren vor, dass die folgenden Schritte durchgeführt werden:
a) Anregen des Schwingkreises mit einer durch einen mit dem Schwingkreis gekoppelten Mikrocontroller bereitgestellten Anregungsspannung. Es kann sich beispielsweise um periodisch wiederholte Spannungspulse, alternativ eine Sinusspannung, handeln. Die Frequenz der periodisch wiederholten Spannung kann beispielsweise zwischen 4 und 10 MHz betragen, beispielsweise 8 MHz.
b) Es erfolgt ein zeitabhängiges Überwachen einer an dem Schwingkreis abfallenden Spannung mit einem parallel zum Schwingkreis geschalteten ADC. Bevorzugt wird ein ADC des auch zum Anregen genutzten Mikrocontrollers genutzt, wodurch das Verfahren besonders kosteneffizient durchführbar ist.

In einer ersten Alternative

c1) erfolgt ein Zählen von Nulldurchgängen der Spannung während eines vorgegebenen Zeitraums mittels des ADC und, wenn die Anzahl der Nulldurchgänge um eine Mindestanzahl von einer vorgegebenen Anzahl abweicht, ein Erkennen der Ortsänderung des Betätigungselements als "betätigt" und dadurch ausgelöst die Ausgabe eines Auslösesignals. Die Durchführung dieses Verfahrensschritts erfolgt bevorzugt vollständig innerhalb es auch bereits zum Anregen genutzten Mikrocontrollers.

In einer zweiten Alternative

c2) erfolgt ein Zählen der Nulldurchgänge der Spannung mittels des ADC und ein Erfassen des Zeitraums bis zum Erreichen einer vorgegebenen Anzahl von Nulldurchgängen und, wenn der Zeitraum um einen Mindestzeitraum von einem vorgegebenen Zeitraum abweicht, Erkennen der Ortsänderung des Betätigungselements als "betätigt" und Ausgabe eines Auslösesignals.

Der Begriff des Nulldurchgangs bedeutet bevorzugt die Querung der 0-Volt-Linie, es kann aber auch ein Offset berücksichtigt sein, sodass der Nulldurchgang ein Durchgang einer festen Spannung ist, die nicht unbedingt identisch mit 0 V sein muss.

Die Anregungsspannung ist bevorzugt von dem Schwingkreis entkoppelte, beispielsweise mittels eines hochohmigen Widerstands.

Die an dem Schwingkreis abfallende Spannung wird bevorzugt über eine, bevorzugt parallel zum Schwingkreis angeordnete, Diode erfasst, wodurch sich eine robustere Signalerkennung ergibt.

Bevorzugt ist die Betätigungsanordnung ein Türgriff einer Fahrzeugtür oder einer Fahrzeugklappe, wobei die induktive Sensoranordnung innerhalb des Türgriffs angeordnet ist. Besonders bevorzugt ist das Betätigungselement an dem Türgriff angeordnet oder Bestandteil des Türgriffs, bevorzugt Bestanteil eines Hüllenabschnitts des Türgriffs.

Die im Zusammenhang mit der Betätigungsanordnung erläuterten Vorteile gelten in verfahrensmäßiger Abwandlung auch für das Verfahren zum Erfassen einer Ortsänderung und seine Weiterbildungen.

Weitere Einzelheiten, Merkmale und Vorteile des Gegenstands der Erfindung ergeben sich aus der nachfolgenden Beschreibung im Zusammenhang mit den Zeichnungen, in denen beispielhaft ein Ausführungsbeispiel der Erfindung dargestellt ist.

Es versteht sich, dass die vorstehend genannten wie auch die nachfolgend erläuterten Merkmale nicht nur in der jeweils angegebenen Kombination, sondern auch in anderen Kombinationen oder in Alleinstellung verwendbar sind.

Es zeigen:
Fig. 1a und 1b: Prinzipskizzen einer Betätigungsanordnung 1;
Fig. 2: schematisches Schaltbild einer induktiven Sensoranordnung;
Fig. 3: Darstellung der Anregungsspannung sowie der überwachten Spannungen zur Erläuterung der Funktionsweise der induktiven Sensoranordnung;
Fig. 4: Prinzipbild einer Betätigungsanordnung zur Realisierung der oben beschriebenen erfindungsgemäßen Variante des Verfahrens.

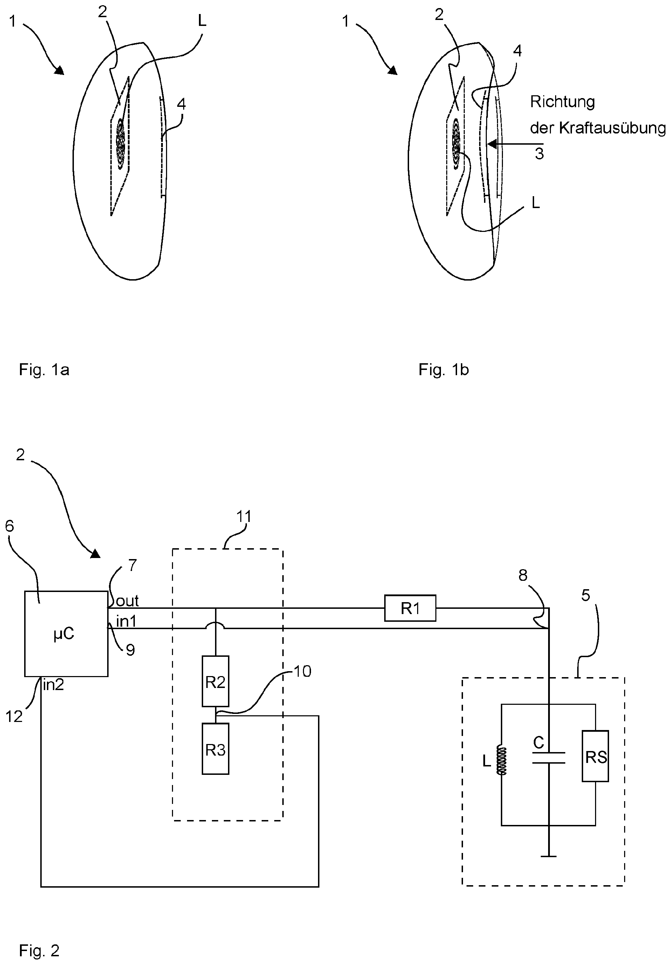

In Fig. 1a ist eine schematische Querschnittsdarstellung einer Betätigungsanordnung 1 eines Kraftfahrzeugs dargestellt. Die Betätigungsanordnung 1 ist in der beispielhaft dargestellten Ausführungsform eine Handhabe eines Türgriffs, welche im Querschnitt dargestellt ist. Innerhalb der Handhabe 1 ist eine induktive Sensoranordnung 2 dargestellt, die in der gezeigten Ausführungsform in ihrer Gesamtheit auf einer Platine angeordnet ist. Die induktive Sensoranordnung weist einen Schwingkreis mit einer Spule L auf. An dem Hüllenabschnitt des Türgriffs und innenseitig des Türgriffs ist ein als Metallfolie ausgebildetes metallisches Betätigungselement 4 angeordnet. Das metallische Betätigungselement 4 ist der Spule L der induktiven Sensoranordnung 2 gegenüberliegend angeordnet. Aufgrund des elastischen Verhaltens des Hüllenabschnitts des Türgriffs ist das metallische Betätigungselement 4 relativ zu der Sensoranordnung 2 beweglich.

In Fig. 1b ist dargestellt, wie infolge der Kraftausübung (symbolisiert durch den dargestellten Pfeil 3) eine Einwirkung auf den Hüllenabschnitt herbeigeführt ist. Infolge der Krafteinwirkung hat das als Metallfolie ausgebildete metallische Betätigungselement 4 eine Lageänderung vollzogen. Die Lageänderung ist Konsequenz einer abschnittsweisen Ortsänderung des Betätigungselements 4 zu der Sensoranordnung 2 als Folge der Verformung des Betätigungselements 4. Die Ortsänderung des Betätigungselements ist insbesondere auch relativ zu der Spule L der Sensoranordnung 2 aufgetreten. Die Sensoranordnung 2 dient dem Zweck, die in der Verformung des Betätigungselements 4 sich ausprägende Betätigung zu erkennen.

Die Erkennung wird auf Basis der nicht erfindungsgemäßen Ausführung der Sensoranordnung 2 durchgeführt. Eine schematisch dargestellte Schaltskizze einer induktiven Sensoranordnung 2 eines Ausführungsbeispiels der Betätigungsanordnung ist in Fig. 2 dargestellt. In Fig. 2 ist eine schematische Darstellung einer Schaltskizze der induktiven Sensoranordnung 2 gezeigt. Die Sensoranordnung 2 weist einen elektrischen Schwingkreis 5 auf, der als Parallelschwingkreis einer Spule L und einer Kapazität C ausgebildet ist. In der gezeigten Darstellung ist außerdem noch ein Widerstand RS vorhanden, der gezielt eingebrachte und/oder die zwangsläufig vorhandenen Eigenwiderstände, insbesondere von L und C sowie der Leiter, repräsentiert. Die Spule L erzeugt bei Anregung mit einer Anregungsspannung ein elektromagnetisches Feld, das mit dem Betätigungselement wechselwirkt, wobei die Wechselwirkung in Abhängigkeit von der Lage beziehungsweise Position des Betätigungselements relativ zu der Spule L ausgeprägt ist.

Die induktive Sensoranordnung 2 weist einen Mikrocontroller 6 auf, der zur Anregung des Schwingkreises 5, zur Überwachung der Reaktion des Schwingkreises 5 sowie zur Auswertung der während der Überwachung erhaltenen Ergebnisse verantwortlich ist. Von einem Ausgang 7 ausgehend ist der Schwingkreis 5 mit einer Versorgungsleitung mit dem Mikrocontroller 6 verbunden. An einer Ankopplungsstelle 8 ist ein erster Spannungsabgriff 8 angeordnet, der zu einem ersten Eingangspin 9 des Mikrocontrollers 6 hinführend mit dem Mikrocontroller 6 gekoppelt ist. Die Sensoranordnung 2 weist einen Leitungszweig 11 auf, welcher in Parallelschaltung zu dem Schwingkreis 5 angeordnet ist. Der Leitungszweig 11 weist einen zweiten Spannungsabgriff 10 auf, von dem ausgehend ein Leiter in einen zweiten Eingangspin 12 des Mikrocontrollers 6 hinführt. Der Leitungszweig 11 dient bei Ausgabe einer Anregungsspannung an dem Ausgangspin 7 des Mikrocontrollers infolge eines unmittelbaren Stromflusses und dadurch Spannungsabfall als Quelle eines Triggersignals, das über den zweiten Eingangspin 12 in den Mikrocontroller 6 hineinführt und von diesem bei Überschreiten einer Startspannung den Startzeitpunkt für einen zu ermittelnden Zeitraum festlegt. Ein Reaktionszeitpunkt wird hiernach festgelegt durch das Überwachen der Spannung über die in den Eingangspin 9 hineingeführte Leitung, die aufgrund des wie dargestellt gewählten Ortes des ersten Spannungsabgriffs 8 ein Maß für die verzögernde Reaktion des Schwingkreises 5 ist. Die verzögerte Reaktion des Schwingkreises ist ihrerseits insbesondere auch Folge der Wechselwirkung der Spule L und dem nicht zur induktiven Sensoranordnung 2 gehörigen aber in definierter Positionierung zu ihr angeordneten metallischen Betätigungselement 4. Der Mikrocontroller 6 ist dadurch in der Lage, den Zeitraum zwischen dem Erfassen des Startsignals beim Eingangspin 12 und dem Erfassen des Stoppsignals bei Eingangspin 9 festzustellen und zu ermitteln, und dann auf Basis einer Auswertung Rückschlüsse dazu abzuleiten, ob eine Ortsänderung des metallischen Betätigungselements vorliegt und gegebenenfalls in welchem Ausmaß diese Ortänderung stattgefunden hat. Bei den Widerständen R1, R2 und R3 handelt es sich durch den Fachmann geeignet zu dimensionierende Widerstände, die für die eigentliche Funktionalität der Betätigungsanordnung aber keine Rolle spielen.

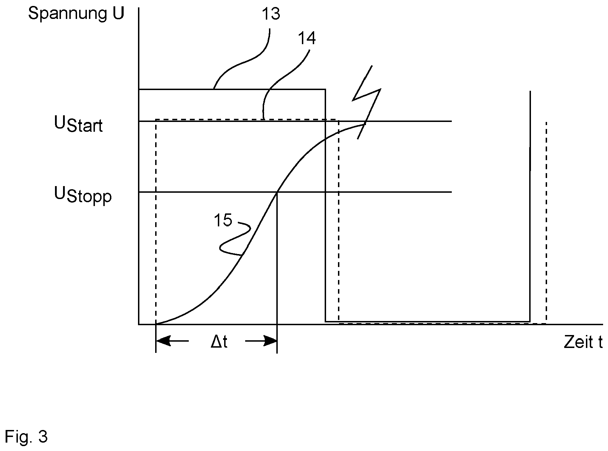

In Fig. 3 ist beispielhaft ein zeitlicher Verlauf der Anregungsspannung 13, der mit nur geringer - in Fig. 3 übertrieben groß dargestellter - Verzögerung an dem zweiten Spannungsabgriff 10 anfallenden Spannung 14, sowie der mit aufgrund der Trägheit des Schwingkreises größeren Zeitverzögerung der an dem ersten Spannungsabgriff 8 erfassten Spannung 15 dargestellt. Es ist zu erkennen, dass quasi unverzüglich nach Ausgabe der Anregungsspannung eine Spannung an dem Spannungsabgriff 10 abfällt und dadurch die Festlegung des Startzeitpunkts erfolgen kann, die beispielsweise ein Starten eines Timers des Mikrocontrollers bewirkt. Es ist zu erkennen, dass in Verzögerung sich die Spannung 15 aufbaut und nach einer gewissen Zeit die vorgegebene Stoppspannung U_{Stopp} erreicht. Der Mikrocontroller erkennt dies, erfasst den Zeitraum Δt zwischen Startzeitpunkt und dem seit dem Startzeitpunkt vergangenen Zeitraum bei Schwellwertüberschreitung der vorgegebenen Stoppspannung. Nach Abgleich von Δt mit einem Referenzwert innerhalb des Mikrocontrollers stellt der Mikrocontroller fest, ob Δt sich um wenigstens eine Minimalabweichung von einem Referenzwert unterscheidet und deswegen auf eine Betätigung des Betätigungselements geschlossen werden kann oder ob Δt weniger als eine Minimalabweichung von dem Referenzwert entfernt liegt und daher nicht von einer Ortsänderung des metallischen Betätigungselements auszugehen ist.

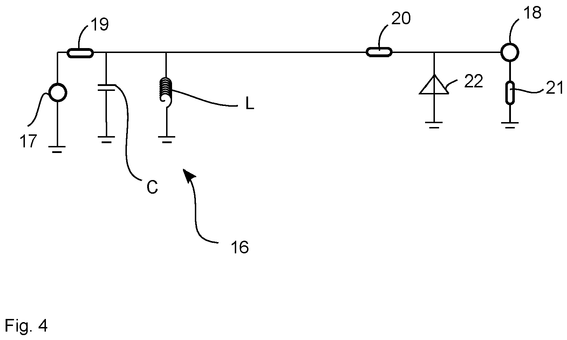

Fig. 4 stellt schematisch eine Betätigungsanordnung dar, mit welcher die oben beschriebene erfindungsgemäße Verfahrensführung realisierbar ist.

Ein Schwingkreis 16, bestehend aus einer Kapazität C und einer Induktivität L, sind mit einem Mikrocontroller 17 gekoppelt und werden über diesen mit einer Anregungsspannung versorgt, beispielsweise mit periodischen Spannungspulsen, alternativ einer Sinusspannung, beispielsweise mit einer Frequenz der periodisch wiederholten Spannung von 8 MHz.

Die an dem Schwingkreis abfallende Spannung wird mit einem parallel zum Schwingkreis geschalteten ADC 18 erfasst, wobei der ADC 18 bevorzugt ein ADC des auch zum Anregen genutzten Mikrocontrollers ist. Der ADC 18 ist in der gezeigten Ausführung zur Verlängerung des Signals über eine Diode 22 mit dem Schwingkreis gekoppelt. Zur Signalentkopplung sind hochohmige Widerstände 19, 20, 21 vorgesehen.

## Patentansprüche

1. Verfahren zum Erfassen einer Ortsänderung eines metallischen Betätigungselements (4), das an einer Betätigungsanordnung (1) eines Kraftfahrzeugs angeordnet ist oder Bestandteil der Betätigungsanordnung (1) des Kraftfahrzeugs ist, relativ zu einer als induktiver Sensor fungierenden Spule (L) eines Schwingkreises (5),
wobei die folgenden Schritte durchgeführt werden:
1) Anregen des Schwingkreises (5) mit einer Anregungsspannung, bevorzugt einer durch einen mit dem Schwingkreis (5) gekoppelten Mikrocontroller (17) bereitgestellten Ausgangsspannung,
2) Überwachen einer an dem Schwingkreis (5) abfallenden Spannung,
3) Feststellen einer Betätigung in Abhängigkeit von der überwachten Spannung,
wobei die folgenden Schritte durchgeführt werden:
a) Anregen des Schwingkreises (16) mit einer durch einen mit dem Schwingkreis (16) gekoppelten Mikrocontroller (17) bereitgestellten Anregungsspannung,
b) zeitabhängiges Überwachen einer an dem Schwingkreis (16) abfallenden Spannung mit einem parallel zum Schwingkreis geschalteten ADC (18), bevorzugt einem ADC (18) des auch zum Anregen (16) genutzten Mikrocontrollers,
c1) Zählen von Nulldurchgängen der Spannung während eines vorgegebenen Zeitraums mittels des ADC und, wenn die Anzahl der Nulldurchgänge um eine Mindestanzahl von einer vorgegebenen Anzahl abweicht, Erkennen der Ortsänderung des Betätigungselements als "betätigt" und Ausgabe eines Auslösesignals oder
c2) Zählen der Nulldurchgänge der Spannung mittels des ADC und Erfassen des Zeitraums bis zum Erreichen einer vorgegebenen Anzahl von Nulldurchgängen und, wenn der Zeitraum um einen Mindestzeitraum von einem vorgegebenen Zeitraum abweicht, Erkennen der Ortsänderung des Betätigungselements als "betätigt" und Ausgabe eines Auslösesignals.

2. Verfahren nach Anspruch 1, wobei
die Anregungsspannung eine von dem Schwingkreis entkoppelte Spannung ist und/oder
die an dem Schwingkreis abfallende Spannung über eine, bevorzugt parallel zum Schwingkreis angeordneten, Diode, erfasst wird.

3. Verfahren nach einem der Ansprüche 1 bis 2, wobei die Anregungsspannung (13) als Spannungspuls, bevorzugt als Rechteckpuls ausgegeben wird; und/oder
die Anregungsspannung (13) zumindest zeitweise periodisch wiederholt ausgegeben wird; und/oder
die Anregungsspannung (13) nach Erhalt eines Näherungssignals eines mit dem Mikrocontroller (6) gekoppelten Näherungssensors ausgegeben wird.

4. Verfahren nach einem der Ansprüche 1 bis 3, wobei die Betätigungsanordnung (1) ein Türgriff einer Fahrzeugtür oder einer Fahrzeugklappe ist, wobei die induktive Sensoranordnung (2) innerhalb des Türgriffs angeordnet ist.

5. Verfahren nach Anspruch 4, wobei das Betätigungselement (4) an dem Türgriff angeordnet ist oder Bestandteil des Türgriffs ist, bevorzugt Bestandteil eines Hüllenabschnitts des Türgriffs.
